# EUROPÄISCHE PATENTANMELDUNG

(11) **EP 0 964 455 A1**
(43) Veröffentlichungstag der Anmeldung: **15.12.1999**
(21) Anmeldenummer: 99108855.0
(22) Anmeldetag: 04.05.1999
(51) Int. Cl.: H01L 29/786, H01L 21/336, H01L 21/265, H01L 21/3115, H01L 29/51, H01L 21/28, H01L 27/12, H01L 21/84, H01L 21/762

(54) **SOI-Halbleiteranordnung und Verfahren zur Herstellung derselben**

(30) Priorität: 15.05.1998 DE 19821999
(71) Anmelder: SIEMENS AKTIENGESELLSCHAFT, 80333 München (DE)
(72) Erfinder: Huttner, Thomas, 87616 Marktoberdorf (DE); Wurzer, Helmut, Dr., 01109 Dresden (DE); Mahnkopf, Reinhard, Dr., Wappingers Falls, NY 12590 (US)

(57) **Zusammenfassung**

Eine Halbleiteranordnung weist eine insbesondere von einem Substrat gebildete Basisschicht (1) aus Halbleitermaterial, eine oberhalb der Basisschicht (1) angeordnete Isolationsschicht (2) und eine an diese angrenzende Schicht (3') aus monokristallinem Silizium auf. Im Bereich der Grenzfläche (7) zwischen der Isolationsschicht (2) und der monokristallinen Siliziumschicht (3') ist ein Passivierstoff unter Ausbildung von Si-X Bindungen vorhanden, wobei die Bindungsenergie der Si-X Bindung größer als die Bindungsenergie einer Si-H Bindung ist.

## Beschreibung

Die Erfindung betrifft eine Halbleiteranordnung nach dem Oberbegriff des Anspruchs 1 und ferner ein Verfahren zur Herstellung einer solchen Halbleiteranordnung nach dem Oberbegriff des Anspruchs 6.

Es ist bereits bekannt, MOS-Feldeffekttransistoren (MOSFETs) auf Silicon-on-Insulator-(SOI-)Substraten aufzubauen. Ein wesentlicher Vorteil dieser Technologie besteht darin, daß im Vergleich zu herkömmlichen, auf Siliziumsubstraten aufgebauten MOSFETs eine vollkommene elektrische Verarmung des Kanals während des Betriebs erreicht werden kann. Dies hat zur Folge, daß sehr geringe Betriebsspannungen (unter 1 V) erreichbar werden, was wiederum die Realisierung von "low-power"-CMOS-Anwendungen mit niedriger Leistungsaufnahme ermöglicht. Ein weiterer günstiger Gesichtspunkt der SOI-Technologie besteht darin, daß aufgrund der sowohl seitlichen als auch vertikalen Isolationswirkung der vergrabenen Oxidschicht sehr hohe Packungsdichten realisierbar sind. Ein aktueller Überblick über die SOI-Technologie und ihre zukünftigen Anwendungsmöglichkeiten ist in dem Artikel "Silicon-on-Insulator-Technologie: Neue "Low Power"-CMOS Anwendungen mit Betriebsspannungen kleiner 0,9 V", Pindl, S. und Risch, L., Phys. Bl. 54 (1998), Nr. 4 gegeben.

Bei herkömmlichen, auf Si-Substraten aufgebauten MOSFETs ist bekannt, daß es durch "heiße Ladungsträger" zu einer Schädigung des Gate-Oxids kommen kann. Dabei brechen die "heißen Ladungsträger" Si-H Bindungen in der Grenzfläche zwischen dem Kanal-Silizium und dem Gate-Oxid auf und erzeugen Grenzflächenzustände (traps), die unerwünscht sind, weil sie zu einer Änderung verschiedener Transistorparameter führen. Die übliche Vorgehensweise zur Vermeidung dieser sogenannten HC-Degradation (HC: hot carrier) besteht darin, einen sanften Übergang der Drain-Dotierung vorzusehen. Diese als LDD-Dotierung (LDD: Lightly Doped Drain) bekannte Maßnahme vermindert die Entstehung von heißen Ladungsträgern und damit eine Schädigung des Gate-Oxids. Nachteilig ist jedoch, daß durch die LDD-Dotierung die Transistoreigenschaften nachteilig beeinflußt werden können.

Der Erfindung liegt die Aufgabe zugrunde, eine auf der SOI-Technologie basierende Halbleiteranordnung zu schaffen, die es ermöglicht, auf ihr hochleistungsfähige SOI-Transistoren auszubilden oder die derartige hochleistungsfähige SOI-Transistoren bereits umfaßt. Ferner zielt die Erfindung darauf ab, ein Verfahren zur Herstellung einer derartigen Halbleiteranordnung anzugeben.

Zur Lösung des ersten Teils der Aufgabenstellung sind die kennzeichnenden Merkmale des Anspruchs 1 vorgesehen.

Die erfindungsgemäße Halbleiteranordnung ist in ihrem Aufbau somit mit einem herkömmlichen SOI-Substrat vergleichbar, wobei jedoch in dem Bereich der Grenzfläche zwischen der Isolationsschicht und der darüber angeordneten monokristallinen Siliziumschicht der Passivierstoff X unter Ausbildung von Si-X Bindungen eingelagert ist. Da die Si-X Bindungen eine größere Bindungsenergie als Si-H Bindungen aufweisen, können sie durch heiße Ladungsträger erheblich schwerer aufgebrochen werden. Die Si-X Bindungen bleiben daher auch bei vergleichsweise hohen kinetischen Ladungsträgerenergien intakt, wodurch die Entstehung von unerwünschten Grenzflächenzuständen im Übergangsbereich zwischen der Isolationsschicht und der monokristallinen Siliziumschicht deutlich verringert wird.

Sind in der erfindungsgemäßen Halbleiteranordnung durch noch näher zu beschreibende Prozeßschritte SOI-Transistoren ausgebildet, hat die erfindungsgemäße Passivierstoffeinlagerung zur Folge, daß eine Schädigung der SOI-Isolationsschicht durch heiße Ladungsträger und eine damit einhergehende Verschlechterung von Transistoreigenschaften nicht oder nur in sehr geringem Umfang eintreten kann.

Vorzugsweise handelt es sich bei dem Passivierstoff X um ein Halogenid und/oder um Stickstoff. Sowohl die Halogenide, insbesondere Fluor und Chlor, als auch Stickstoff bilden mit Silizium eine Bindung aus, deren Bindungsenergie deutlich höher als die Bindungsenergie der Si-H Bindung ist.

Eine besonders bevorzugte Ausführungsform der Erfindung kennzeichnet sich dadurch, daß in der monokristallinen Siliziumschicht seitlich benachbarte, unterschiedlich dotierte Gebiete ausgebildet sind, die Source, Kanal und Drain eines MOS-FETs bilden, und daß oberhalb des Kanalbereichs eine Gate-Oxidschicht und darüberliegend eine das Gate des MOSFETs bildende elektrische Anschlußstruktur angeordnet sind. In diesem Fall schafft die Isolationsschicht eine gegenüber HC-Degradation resistente Isolierung des Source-, Kanal- und Drain-Gebiets des SOI-MOSFETs gegenüber der Basisschicht und gewährleistet somit einen hohen Drain-Strom des Transistors.

In diesem Fall kennzeichnet sich eine vorteilhafte Ausführungsform der Erfindung dadurch, daß der Passivierstoff X auch im Bereich einer Grenzfläche zwischen dem Kanalgebiet der monokristallinen Siliziumschicht und der Gate-Oxidschicht unter Ausbildung von Si-X Bindungen eingelagert ist. Dann ist neben der Isolationsschicht auch die Gate-Oxidschicht passiviert, d.h. gegenüber HC-Degradation geschützt. Die Konzentration des Passivierstoffes X an den Grenzflächen kann dabei etwa 10¹⁸ cm-³ betragen.

Die elektrische Isolation benachbarter MOSFETs kann grundsätzlich durch eine der bekannten Technologien, beispielsweise LOCOS (Local Oxidation of Silicon) oder STI (Shallow Trench Isolation) erfolgen. Vorzugsweise werden benachbarte MOSFETs jedoch durch Mesa-Isolation elektrisch voneinander getrennt. Bei dieser Technik wird die Siliziumschicht im Bereich zwischen zwei SOI-MOSFETs bis auf die darunterliegende Isolationsschicht entfernt, wobei in vorteilhafter Weise hohe Packungsdichten erzielbar sind.

Der zweite Teil der erfindungsgemäßen Aufgabenstellung wird gemäß den kennzeichnenden Merkmalen des Anspruchs 6 gelöst.

Bei dem erfindungsgemäßen Verfahren kann der Passivierstoff X entweder während oder nach der Herstellung der Halbleiterstruktur in die Isolationsschicht und/oder die monokristalline Siliziumschicht eingebracht werden. Durch das anschließende Tempern wird erreicht, daß der eingebrachte Passivierstoff X in den Bereich der Grenzfläche diffundiert und dort vorhandene Si-H Bindungen durch Si-X Bindungen ersetzt.

Vorzugsweise wird der Passivierstoff X durch Ionenimplantation in die entsprechende(n) Schicht(en) eingebracht. Durch die Ionenimplantationstechnik wird ein sehr gezielt dosierbares und lagegenaues Deponieren des Passivierstoffes X ermöglicht. Ferner ist vorteilhaft, daß der Passivierstoff X durch die obere monokristalline Siliziumschicht oder gegebenenfalls auch noch weitere Deckschichten hindurch in die Isolationsschicht eingebracht werden kann. Das Einbringen des Passivierstoffes X kann daher zeitlich nach der Herstellung der SOI-Halbleiterstruktur erfolgen, so daß dem erfindungsgemäßen Verfahren auch im Handel erhältliche vorgefertigte SOI-Halbleiterstrukturen zugrunde gelegt werden können.

Die Verwendung eines Implantationsschrittes zum Einbringen des Passivierstoffes X in eine SOI-Halbleiterstruktur kann insbesondere dann von Vorteil sein, wenn auch die SOI-Halbleiterstruktur durch einen Ionenimplantationsprozeß hergestellt wird. Dies ist bei der sogenannten SIMOX-(Separation by Implementation of Oxygen-)Technik der Fall, bei der die Isolationsschicht in Form einer vergrabenen SiO₂-Schicht durch Implantation einer hohen Sauerstoffdosis in ein monokristallines Siliziumsubstrat gebildet wird. Der Implantationsschritt zum Einbringen des Passivierstoffes X kann sich dann unmittelbar an den Sauerstoff-Implantationsschritt zur Ausbildung der SOI-Halbleiterstruktur anschließen, und die beiden Schritte können in fertigungstechnisch günstiger Weise in ein und derselben Implantationsanlage durchgeführt werden. Ferner ist es auch möglich, den erfindungsgemäßen Passivierstoff-Implantationsschritt vor der Sauerstoffimplantation auszuführen.

Eine weitere Möglichkeit besteht darin, den Passivierstoff X durch einen Diffusionsschritt in die SOI-Halbleiterstruktur einzubringen. Ein hierfür geeignetes Herstellungsverfahren für SOI-Halbleiterstrukturen ist in der Technik als BESOI-(Bonded Etched-back Silicon on Insulator)-Verfahren bekannt. Bei diesem Verfahren werden zwei Silizium-Halbleitersubstrate zunächst jeweils mit einer oberflächenseitigen Oxidschicht versehen. Die beiden Silizium-Halbleitersubstrate werden dann durch Kontaktierung ihrer Oxidschichten zusammengefügt und eines der Silizium-Halbleitersubstrate wird zur Ausbildung der oberen monokristallinen Siliziumschicht bis auf eine dünne Restschicht abgetragen. Gemäß einer erfindungsgemäßen Ausführungsvariante wird das BESOI-Verfahren nun in der Weise modifiziert, daß der Passivierstoff X vor dem Zusammenfügen der beiden Silizium-Halbleitersubstrate in eine oder beide Oxidschichten und/oder vor oder nach dem Oxidationsschritt in eines der Silizium-Halbleitersubstrate eingebracht wird. Das Einbringen des Passivierstoffes X kann hier einfach durch eine thermische Dotierung (Diffusion des Passivierstoffes aus einem Passivierstoffgas in die entsprechende Schicht) erfolgen, da die zu passivierenden Schichten vor dem Zusammenfügen der beiden Silizium-Halbleitersubstrate freiliegend sind.

Um bei dem nach dem Einbringen des Passivierstoffes X durchzuführenden Temperschritt kurze Diffusionswege zu erzielen, ist es zweckmäßig, das Implantationsmaximum des Passivierstoffes X in die Nähe der Grenzfläche zu der monokristallinen Siliziumschicht zu legen.

Vorzugsweise wird auf der obenliegenden monokristallinen Siliziumschicht eine Deckoxidschicht aufgebracht. Diese Deckoxidschicht kann bei nachfolgenden Implantationsschritten als Streuschicht dienen.

Das Einbringen des Passivierstoffes X in die Isolationsschicht und/oder die monokristalline Siliziumschicht kann sowohl vor als auch nach einer gegebenenfalls durchzuführenden Strukturierung der monokristallinen Siliziumschicht erfolgen. Ein Vorteil der letztgenannten Möglichkeit besteht darin, daß der Passivierstoff X beim Einbringen in die Isolationsschicht und/oder die Siliziumschicht gleichzeitig in sogenannte Spacer (Abstandsstücke) eingelagert werden kann, die zuvor an Stufen der strukturierten monokristallinen Siliziumschicht ausgebildet wurden. Auf diese Weise werden auch die Spacer passiviert, wodurch die Bildung von unerwünschten Mesa-Seitenwandtransistoren wirkungsvoll unterdrückt werden kann.

Weitere vorteilhafte Ausgestaltungen der Erfindung sind in den Unteransprüchen angegeben.

Die Erfindung wird nachfolgend in beispielhafter Weise anhand der Beschreibung von vier Ausführungsvarianten des erfindungsgemäßen Verfahrens unter Bezugnahme auf die Zeichnung erläutert; in dieser zeigt:
- Fig. 1a bis f: eine erste Ausführungsvariante, bei der der Passivierstoff X vor der Strukturierung der Siliziumschicht durch Implantation in eine vergrabene Oxidschicht eingebracht wird;
- Fig. 2a bis f: eine zweite Ausführungsvariante, bei der der Passivierstoff X vor der Strukturierung der Siliziumschicht durch Implantation in die Siliziumschicht eingebracht wird;
- Fig. 3a bis f: eine dritte Ausführungsvariante der Erfindung, bei der der Passivierstoff X nach der Strukturierung der Silizumschicht durch Implantation in eine vergrabene Oxidschicht eingebracht wird; und
- Fig. 4a bis f: eine vierte Ausführungsvariante der Erfindung, bei der der Passivierstoff X nach der Strukturierung der Siliziumschicht durch Implantation in die Siliziumschicht eingebracht wird.

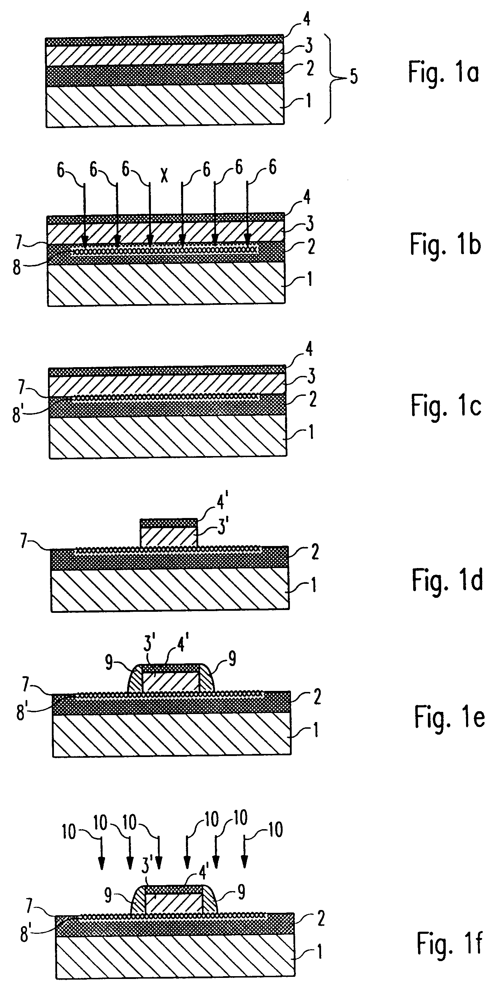

Nach Fig. 1a umfaßt eine SOI-Halbleiterstruktur 5 eine von einem Si-Substrat gebildete Si-Basisschicht 1, an die sich eine vergrabene Oxidschicht 2 anschließt, welche von einer monokristallinen Siliziumschicht 3 überlagert ist. Die SOI-Halbleiterstruktur 5 kann beispielsweise nach den bereits erwähnten SIMOX- oder BESOI-Techniken hergestellt sein und ist im Handel als fertiges Produkt erhältlich. Ferner können die Si-Basisschicht 1 und die monokristalline Siliziumschicht 3 herstellerseitig bereits p- oder n-vordotiert sein.

Auf der SOI-Halbleiterstruktur 5 wird gemäß Fig. 1a zunächst eine Streuoxidschicht 4 gebildet. Die Bildung der Streuoxidschicht 4 kann beispielsweise durch thermische Oxidation der monokristallinen Siliziumschicht 3 oder durch Ablagerung einer TEOS-(Tetra-Ethyl-Ortho-Selicate)-Schicht mittels eines CVD-Verfahrens erfolgen.

Nach Fig. 1b wird anschließend der Passivierstoff X durch Implantation in die vergrabene Oxidschicht 2 ganzflächig oder großflächig eingelagert. Der Implantationsschritt ist durch Pfeile 6 verdeutlicht. Als Passivierstoff X wird beispielsweise Stickstoff, Fluor oder Chlor verwendet. Die Einlagerung kann in bezug auf die Einlagerungstiefe, die Einlagerungsdosis und das Einlagerungsprofil sehr gezielt gesteuert werden. Da der Passivierstoff X im Bereich der Grenzfläche 7 zwischen monokristalliner Siliziumschicht 3 und vergrabener Oxidschicht 2 zur Anwendung kommen soll, werden bei dem Implantationsschritt Bedingungen gewählt, die bewirken, daß das Implantationsmaximum 8 kurz unterhalb der Grenzfläche 7 liegt.

Nachfolgend wird ein Temperschritt (Wärmebehandlungsschritt) durchgeführt. Dabei diffundiert der in die vergrabene Oxidschicht 2 implantierte Passivierstoff X zu der Grenzfläche 7, wobei sich auch die Passivierstoffverteilung 8' in den Bereich der Grenzfläche 7 verlagert. Dabei werden im Bereich der Grenzfläche 7 vorhandene Si-H Bindungen durch die energetisch stabileren Si-X Bindungen ersetzt. Dadurch wird in der bereits beschriebenen Weise die Schädigungsfestigkeit der vergrabenen Oxidschicht 2 gegenüber HC-Degradation erhöht. Ferner bewirkt der Temperschritt ein Ausheilen von Schäden bzw. Defekten, die bei dem Implantationsschritt in den oberen Schichten 3 und 4 aufgetreten sind. In Fig. 1c ist die Situation nach der Durchführung des Temperschrittes dargestellt. Die Konzentration des Passivierstoffes X kann beispielsweise etwa 10¹⁸ cm⁻³ betragen.

Die Fig. 1d bis f zeigen in beispielhafter Weise weitere Prozeßschritte, die für die Strukturierung und Isolation der monokristallinen Siliziumschicht 3 zur Ausbildung eines SOI-MOSFETs durchgeführt werden. Derartige Schritte sind auch zum Aufbau einer integrierten CMOS-Schaltung auf der SOI-Halbleiterstruktur 5 erforderlich. Zunächst werden gemäß Fig. 1d unter Verwendung von üblichen photolithographischen Maskierungstechniken und Ätzschritten die Streuoxidschicht 4 und die monokristalline Siliziumschicht 3 bis auf lokal zurückbleibende Schichtbereiche 3', 4' abgetragen. Dadurch wird der monokristalline Schichtbereich 3' von in Fig. 1d nicht dargestellten entsprechenden benachbarten Schichtbereichen elektrisch isoliert. Das hier gezeigte Verfahren ist in der Technik als Mesa-Isolation bekannt. Anstelle der Mesa-Isolation können auch andere Isolationsverfahren (beispielsweise LOCOS, STI) Anwendung finden.

Nach Fig. 1e werden die Umfangswände des Schichtbereichs 3', 4' mit Spacern (Abstandsstücken) 9 überzogen. Die Spacer 9 dienen der zusätzlichen Isolierung der Umfangswände der freistehenden Schichtbereiche 3', 4'.

Schließlich wird gemäß Fig. 1f durch einen weiteren Implantationsschritt die Kanaldotierung des zu schaffenden SOI-MOSFETs herbeigeführt. Der Kanalimplantationsschritt ist durch die Pfeile 10 angedeutet.

Durch Verwendung von nicht dargestellten Implantationsmasken können die Implantationsschritte (Fig. 1b, Fig. 1f) ortsselektiv durchgeführt werden. Insbesondere kann eine Implantation des Passivierstoffes X gezielt beispielsweise nur in n-Kanal-Transistoren erfolgen.

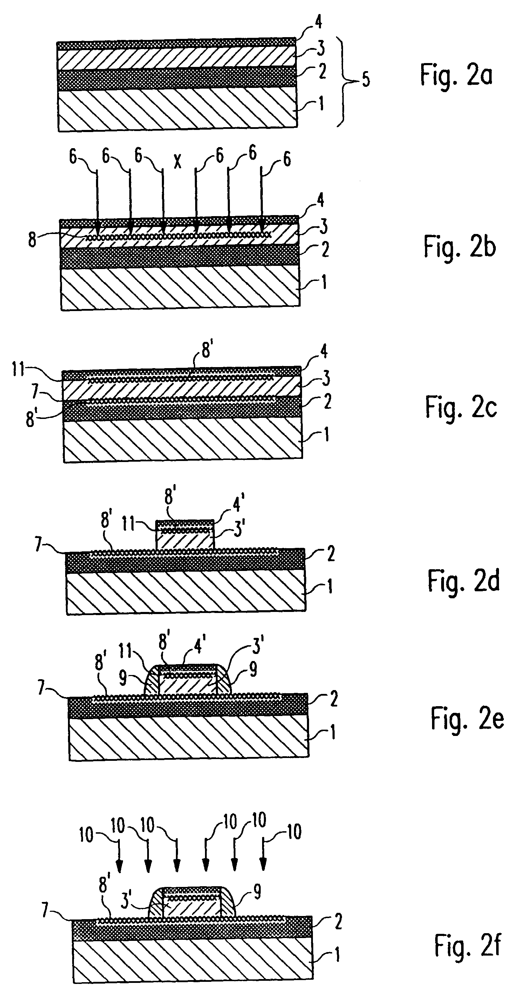

Die in den Fig. 2a bis 2f dargestellte zweite Verfahrensvariante unterscheidet sich von der in den Fig. 1a bis f gezeigten ersten Verfahrensvariante im wesentlichen lediglich dadurch, daß das Implantationsmaximum 8 nicht in der vergrabenen Oxidschicht 2, sondern in der monokristallinen Siliziumschicht 3 liegt. Dabei sollte die implantierte Dosis des Passivierstoffes X unterhalb der amorphisierenden Dosis in Silizium liegen. Gemäß Fig. 2c diffundiert der implantierte Passivierstoff X bei dieser Variante sowohl zu der Grenzfläche 7 zwischen vergrabener Oxidschicht 2 und monokristalliner Siliziumschicht 3 als auch zu einer Grenzfläche 11 zwischen monokristalliner Siliziumschicht 3 und Streuoxidschicht 4. Damit ist nach einem Abtragen der Streuoxidschicht 4 und einem späteren Aufwachsen einer Gate-Oxidschicht auf die monokristalline Siliziumschicht 3 in dieser noch genügend Passivierstoff X im grenzflächennahen Bereich vorhanden, um die Widerstandsfähigkeit auch der Gate-Oxidschicht gegen Schädigung durch heiße Ladungsträger zu erhöhen.

Die in den Fig. 2d bis 2f dargestellten Schritte der Strukturierung/Isolation, Spacer-Ausbildung und Kanalimplantation werden analog zu den in den Fig. 1d bis 1f dargestellten Schritten durchgeführt.

Der in Fig. 2c gezeigte Temperschritt kann auch nach der Mesa-Isolation (Fig. 2d) und dem Anbringen der Spacer 9 (Fig. 2e) durchgeführt werden. Dann befindet sich der Passivierstoff X nur in den von den Schichtbereichen 3', 4' überdeckten Abschnitten der Grenzflächen 7, 11, d.h. in den aktiven Gebieten. Bei Verwendung von Spacern 9 aus Siliziumoxid und einem Stickstoff-Passivierstoff X werden in diesem Fall auch die an die Umfangswände der Schichtbereiche 3', 4' angrenzenden Spacer-Innenwände nitridiert. Bei der anschließenden Kanaldotierung (Fig. 2f) hemmt dies die Ausdiffusion von Kanaldotierstoff in die Spacer und unterdrückt somit in erwünschter Weise die Bildung von Mesa-Seitenwandtransistoren.

Als Passivierstoff X verwendete Halogene beschleunigen hingegen die Diffusion von Kanaldotierstoff, insbesondere Bor in aus Siliziumoxid gebildete Spacer 9. Zur Vermeidung von Seitenwandtransistoren werden in diesem Fall aus Siliziumnitrid gebildete Mesa-Spacer 9 eingesetzt.

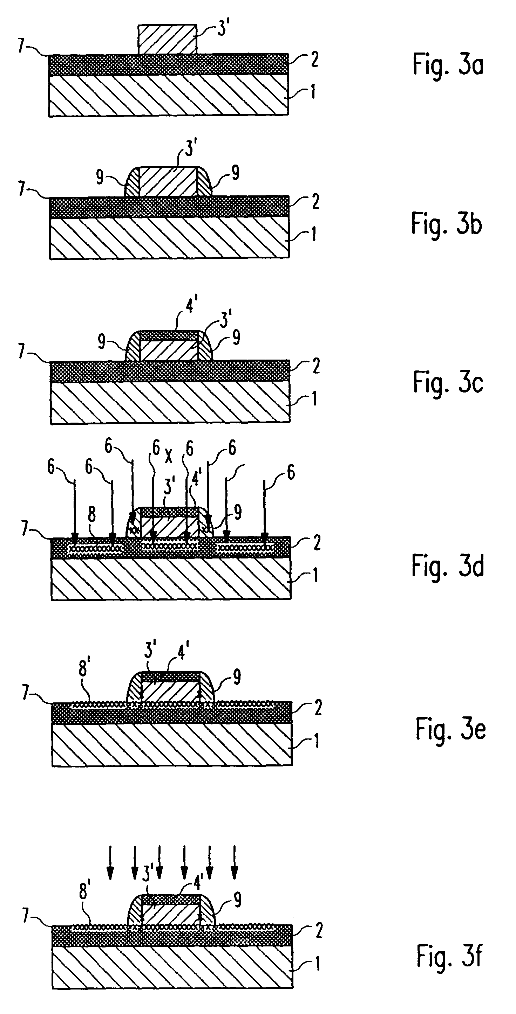

Bei der in den Fig. 3a bis 3f dargestellten dritten Ausführungsvariante des erfindungsgemäßen Verfahrens wird der Passivierstoff X wie bei der ersten Ausführungsvariante (Fig. 1a bis f) in die vergrabene Oxidschicht 2 eingebracht. Der entsprechende Implantationsschritt ist in der Fig. 3d dargestellt. Im Unterschied zu der ersten Ausführungsvariante erfolgt hier jedoch die Strukturierung/Isolation sowie die Ausbildung der Mesa-Spacer 9 und eine nachfolgende thermische Oxidation des monokristallinen Schichtbereichs 3' zur Ausbildung des Streuschichtbereichs 4' (siehe Fig. 3a bis c) bereits vor dem Passivierstoff-Implantationsschritt.

Bestehen die Spacer 9 aus Siliziumoxid, hat dies zur Folge, daß der Passivierstoff X auch in die Mesa-Spacer 9 implantiert wird, da die Implantationstiefe in Siliziumoxid geringer als in monokristallinem Silizium ist. Dadurch findet die bei der zweiten Ausführungsvariante beschriebene Unterdrückung von Mesa-Seitenwandtransistoren bei Verwendung von Stickstoff als Passivierstoff X auch hier statt. Fig. 3e zeigt die sich nach dem Temperschritt im Bereich der Grenzfläche 7 und an den Umfangswänden des monokristallinen Schichtbereichs 3' ergebende Verteilung 8' des Stickstoffs. Bei Verwendung von Halogenen als Passivierstoff sollten - wie bereits im Zusammenhang mit der zweiten Ausführungsvariante beschrieben - Spacer 9 eingesetzt werden, die aus Siliziumnitrid bestehen.

Fig. 3f zeigt wiederum den Schritt der Kanalimplantation.

Wird der in Fig. 3e dargestellte Temperschritt erst nach der Kanalimplantation (Fig. 3f) ausgeführt, kann die bei der Kanalimplantation verwendete, nicht dargestellte Wannen-Photomaske dazu benutzt werden, um ohne Zusatzaufwand auch die Implantation des Passivierstoffs X zu maskieren. Auch bei dieser Vorgehensweise wird der Passivierstoff X in die Mesa-Spacer 9 implantiert, sofern diese aus Siliziumoxid bestehen.

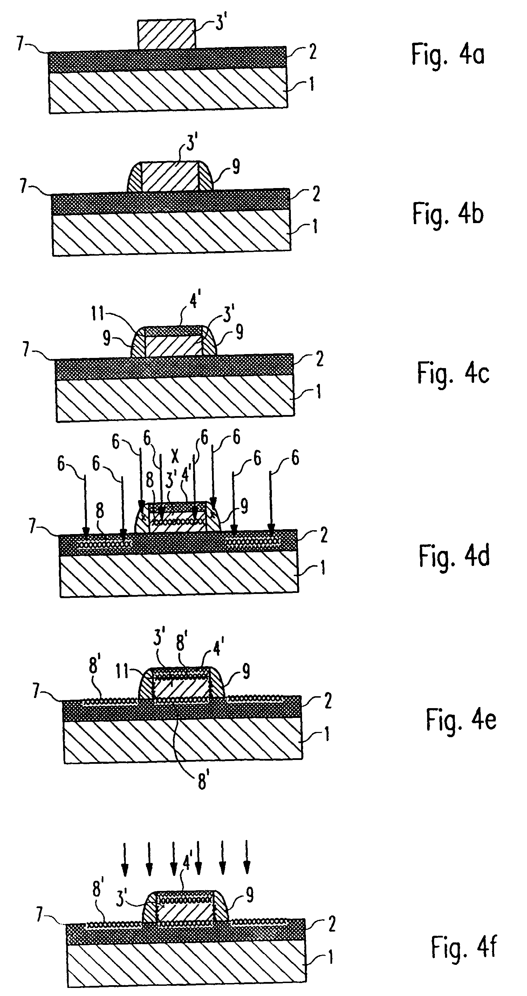

Die Fig. 4a bis 4f zeigen eine vierte Ausführungsvariante des erfindungsgemäßen Verfahrens. Hier erfolgt wie bei der dritten Ausführungsvariante die Strukturierung/Isolation, die Mesa-Spacer-Bildung und die thermische Oxidation des aktiven Siliziumschichtbereichs 3' (Fig. 4a bis 4c) vor dem Einbringen des Passivierstoffes X durch einen Implantationsschritt (Fig. 4d). Im Unterschied zu der dritten Ausführungsvariante wird hier eine geringere Implantationsenergie gewählt, so daß das Implantationsmaximum 8 innerhalb des monokristallinen Si-Schichtbereichs 3' liegt. Eine Implantation in die Spacer 9 findet auch hier statt. Fig. 4e zeigt die Verteilung 8' des Passivierstoffes X nach dem Temperschritt. Der Vorteil dieser Ausführungsvariante liegt in der zusätzlichen Passivierung (Halogenierung oder Nitridierung) des später aufzuwachsenden Gate-Oxids (vgl. auch die zweite Ausführungsvariante) und - bei der Verwendung von Stickstoffimplantation und Oxid-Spacern 9 - in der Nitridierung der Mesa-Spacer-Innenseite zur Unterdrückung von Mesa-Seitenwandtransistoren. Fig. 4e zeigt, daß der aktive monokristalline Silizium-Schichtbereich 3' allseitig vollständig passiviert ist.

Bei der Verwendung von Halogenen als Passivierstoff X sollten wiederum Spacer 9 aus Siliziumnitrid verwendet werden. Außerdem besteht wie bei der dritten Ausführungsvariante die Möglichkeit, bei der Maskierung des Passivierstoff-Implantationsschrittes (Fig. 4d) dieselbe Maske wie bei dem Kanalimplantationsschritt (Fig. 4f) zu verwenden.

Die folgende Tabelle zeigt die Bindungsenergien von Silizium mit Wasserstoff sowie den Passivierstoffen Stickstoff, Fluor und Chlor. Es wird deutlich, daß die Si-X Bindung bei Verwendung der genannten Passivierstoffe X eine deutlich höhere Bindungsenergie aufweist als bei Verwendung von Wasserstoff als Bindungspartner.

**Tabelle**

| Bindungsenergien von Siliziumbindungen | |
|---|---|
| Bindung | Bindungsenergie [eV] |
| Si-H | 3,1 |
| Si-N | 4,6 |
| Si-F | 5,7 |
| Si-Cl | 4,7 |

## Patentansprüche

1. Halbleiteranordnung mit
- einer insbesondere von einem Substrat gebildeten Basisschicht (1) aus Halbleitermaterial,
- einer oberhalb der Basisschicht (1) angeordneten Isolationsschicht (2), und
- einer oberhalb der Isolationsschicht (2) angeordneten, an diese angrenzende Schicht (3, 3') aus monokristallinem Silizium,
**dadurch gekennzeichnet**,
- daß im Bereich der Grenzfläche (7) zwischen der Isolationsschicht (2) und der monokristallinen Siliziumschicht (3, 3') ein Passivierstoff X unter Ausbildung von Si-X Bindungen vorhanden ist, und
- daß die Bindungsenergie der Si-X Bindung größer als die Bindungsenergie einer Si-H Bindung ist.

2. Halbleiteranordnung nach Anspruch 1, dadurch gekennzeichnet, daß es sich bei dem Passivierstoff X um ein Halogen und/oder um Stickstoff handelt.

3. Halbleiteranordnung nach einem der Ansprüche 1 oder 2, dadurch gekennzeichnet,
- daß in der monokristallinen Siliziumschicht (3, 3') seitlich benachbarte unterschiedlich dotierte Gebiete ausgebildet sind, die Source, Kanal und Drain eines MOSFETs bilden, und
- daß oberhalb des Kanalgebiets eine Gate-Oxidschicht und darüberliegend eine das Gate des MOSFETs bildende elektrische Anschlußstruktur angeordnet sind.

4. Halbleiteranordnung nach Anspruch 3, dadurch gekennzeichnet, daß der Passivierstoff X ferner im Bereich einer Grenzfläche (11) zwischen dem Kanalgebiet der monokristallinen Siliziumschicht (3, 3') und der Gate-Oxidschicht unter Ausbildung von Si-X Bindungen vorhanden ist.

5. Halbleiteranordnung nach einem der Ansprüche 3 oder 4, dadurch gekennzeichnet,
- daß die Halbleiteranordnung eine Mehrzahl von MOSFETs umfaßt, und
- daß zwei benachbarte MOSFETs durch Mesa-Isolation voneinander getrennt sind.

6. Verfahren zur Herstellung einer gemäß einem der vorhergehenden Ansprüche aufgebauten Halbleiteranordnung, gekennzeichnet durch die Schritte:
- Herstellen oder Bereitstellen einer aus der Basisschicht (1), der Isolationsschicht (2) und der monokristallinem Siliziumschicht (3) aufgebauten Halbleiterstruktur (5);
- Einbringen des Passivierstoffes X in die Isolationsschicht (2) und/oder in die monokristalline Siliziumschicht (3, 3') entweder während oder nach der Herstellung der Halbleiterstruktur (5); und
- Durchführen eines Temperschrittes.

7. Verfahren nach Anspruch 6, dadurch gekennzeichnet, daß der Passivierstoff X durch Ionenimplantation in die Isolationsschicht (2) und/oder in die monokristalline Siliziumschicht (3, 3') eingebracht wird.

8. Verfahren nach Anspruch 7, dadurch gekennzeichnet, daß bei in die Isolationsschicht (2) eingebrachten Passivierstoff X das Implantationsmaximum (8) des Passivierstoffes X in die Nähe der Grenzfläche zu der monokristallinen Siliziumschicht (3, 3') gelegt wird.

9. Verfahren nach Anspruch 6, dadurch gekennzeichnet, daß der Passivierstoff X bereits während der Herstellung der Halbleiterstruktur (5) mittels der folgenden Schritten in diese eingebracht wird:
- Bereitstellen zweier Silizium-Halbleitersubstrate;
- Ausbilden jeweils einer Oxidschicht auf beiden Silizium-Halbleitersubstraten;
- Einbringen des Passivierstoffes X in eine oder beide der Oxidschichten und/oder Einbringen des Passivierstoffes X vor oder nach dem Oxidationsschritt in eines der Silizium-Halbleitersubstrate;
- Zusammenfügen der beiden Silizium-Halbleitersubstrate durch eine Kontaktierung ihrer Oxidschichten, und
- teilweises Abtragen eines der Silizium-Halbleitersubstrate zur Ausbildung der monokristallinen Siliziumschicht (3, 3').

10. Verfahren nach einem der Ansprüche 6 bis 9, dadurch gekennzeichnet, daß auf die monokristalline Siliziumschicht (3, 3') eine Deckoxidschicht (4, 4') aufgebracht wird.

11. Verfahren nach einem der Ansprüche 6 bis 10, dadurch gekennzeichnet, daß die monokristalline Siliziumschicht (3, 3') durch bereichsweises Wegätzen bis zu der darunterliegenden Isolationsschicht (2) strukturiert wird.

12. Verfahren nach Anspruch 11, dadurch gekennzeichnet, daß der Strukturierungsschritt vor oder nach dem Einbringen des Passivierstoffes X in die Isolationsschicht (2) und/oder die monokristalline Siliziumschicht (3, 3') erfolgt.

13. Verfahren nach einem der Ansprüche 6 bis 12, dadurch gekennzeichnet,
- daß die monokristalline Siliziumschicht (3, 3') durch Ionenimplantation gebietsweise unterschiedlich dotiert wird, und
- daß dieser Dotierschritt nach dem Einbringen des Passivierstoffes X in die Isolationsschicht (2) und/oder die monokristalline Siliziumschicht (3, 3') und dem Temperschritt erfolgt.
